(19) Europäisches Patentamt
European Patent Office
Office européen des brevets

(11) **EP 3 903 116 B1**

(12) **EUROPÄISCHE PATENTSCHRIFT**

(45) Veröffentlichungstag und Bekanntmachung des Hinweises auf die Patenterteilung:
**06.09.2023 Patentblatt 2023/36**

(21) Anmeldenummer: **19832661.3**

(22) Anmeldetag: **19.12.2019**

(51) Internationale Patentklassifikation (IPC):
**G01R 31/34** *(2020.01)* **G01R 19/00** *(2006.01)*
**G01R 31/28** *(2006.01)*

(52) Gemeinsame Patentklassifikation (CPC):
**G01R 31/34; G01R 19/0092; G01R 31/2829**

(86) Internationale Anmeldenummer:
**PCT/EP2019/086301**

(87) Internationale Veröffentlichungsnummer:
**WO 2020/136076 (02.07.2020 Gazette 2020/27)**

(54) **VERFAHREN ZUM ERMITTELN EINES VERSTÄRKUNGSFEHLERS EINER STROMMESSEINRICHTUNG**

METHOD FOR DETERMINING A GAIN ERROR OF A CURRENT MEASURING DEVICE

PROCÉDÉ DE DÉTERMINATION D'UNE ERREUR D'AMPLIFICATION D'UN AMPÈREMÈTRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.12.2018 DE 102018251746**

(43) Veröffentlichungstag der Anmeldung:
**03.11.2021 Patentblatt 2021/44**

(73) Patentinhaber: **Robert Bosch GmbH**
**70442 Stuttgart (DE)**

(72) Erfinder:
• **CHEN, Yuping**
**71706 Markgroeningen (DE)**
• **GOETTING, Gunther**
**70499 Stuttgart (DE)**
• **CHEN, Lei**
**70437 Stuttgart (DE)**

(56) Entgegenhaltungen:
• **HARKE M C ET AL: "Current Measurement Gain Tuning Using High-Frequency Signal Injection", IEEE TRANSACTIONS ON INDUSTRY APPLICATIONS, IEEE SERVICE CENTER, PISCATAWAY, NJ, US, Bd. 44, Nr. 5, 1. September 2008 (2008-09-01), Seiten 1578-1586, XP011446018, ISSN: 0093-9994, DOI: 10.1109/TIA.2008.2002170**
• **HARKE M C ET AL: "The Spatial Effect and Compensation ofCurrent Sensor Differential Gains for Three-Phase Three-Wire Systems", IEEE TRANSACTIONS ON INDUSTRY APPLICATIONS, IEEE SERVICE CENTER, PISCATAWAY, NJ, US, Bd. 44, Nr. 4, 1. Juli 2008 (2008-07-01), Seiten 1181-1189, XP011231802, ISSN: 0093-9994, DOI: 10.1109/TIA.2008.926208**

**Beschreibung**

Die Erfindung betrifft ein Verfahren zum Ermitteln eines Verstärkungsfehlers einer Strommesseinrichtung einer Sensoreinheit einer elektrischen Maschine, wobei die Maschine eine Statorwicklung mit zumindest drei Phasen und einen Rotor aufweist, der um eine Rotationsachse drehbar gelagert ist.

Außerdem betrifft die Erfindung eine Vorrichtung zum Durchführen des eingangs genannten Verfahrens.

Stand der Technik

Elektrische Maschinen der eingangs genannten Art sind aus dem Stand der Technik bekannt. Elektrische Antriebsmaschinen von Elektrofahrzeugen oder Hybridfahrzeugen weisen in der Regel eine Statorwicklung mit zumindest drei Phasen sowie einen Rotor auf, der um eine Rotationsachse drehbar gelagert und durch eine geeignete Bestromung der Phasen zur Erzeugung eines Drehmoments drehbar beziehungsweise antreibbar ist.

Um eine vorteilhafte Bestromung der Phasen zum Antreiben des Rotors zu gewährleisten, ist es notwendig, während der Bestromung der Phasen einen elektrischen Strom durch die Phasen zu erfassen. Dies wird beispielsweise durch eine Sensoreinheit gewährleistet, die zumindest drei Strommesseinrichtungen aufweist, wobei jede der Strommesseinrichtungen zum Erfassen des Stroms durch die Phasen jeweils einer anderen der Phasen zugeordnet ist. Üblicherweise wird der erfasste Strom verstärkt. Dabei wird ein Wert des Stroms, also ein Eingangswert, gemäß einem insbesondere proportionalen Zusammenhang vergrößert, sodass ein Ausgangswert größer ist als der Eingangswert. Bei der Verstärkung können sogenannte Verstärkungsfehler (gain error) auftreten. Unter einem Verstärkungsfehler ist zu verstehen, dass eine tatsächliche Funktion zur Erzeugung des Ausgangswertes aus dem Eingangswert von einer idealen beziehungsweise erwarteten Funktion abweicht, sodass der tatsächliche Ausgangswert größer oder kleiner ist als der ideale beziehungsweise erwartete Ausgangswert. Um Verstärkungsfehler zu erfassen beziehungsweise zu beheben schlägt die Veröffentlichung "*The Spatial Effect and Compensation of Current Sensor Differential Gains for Three-Wire Systems*" (DOI: 10.1109/TIA.2008.926208) vor, eine positive Sequenzkomponente eines Arbeitsstroms zum Antreiben eines Rotors zu erfassen und in Abhängigkeit von der positiven Sequenzkomponente die Verstärkung zu kalibrieren. Aus der Veröffentlichung "Current Measurement Gain Tuning Using High-Frequency Signal Injection" (DOI: 10.1109/TIA.2008.2002170) ist ein Verfahren zum Ermitteln eines Verstärkungsfehlers bekannt.

Offenbarung der Erfindung

Das erfindungsgemäße Verfahren mit den Merkmalen des Anspruchs 1 hat den Vorteil, dass ein zuverlässiges Ermitteln von Verstärkungsfehlern ermöglicht wird. Insbesondere sind Verstärkungsfehler auch im Stillstand des Rotors erfassbar. Erfindungsgemäß ist dazu vorgesehen, dass in einem Schritt a) eine elektrische Sensorspannung an den Phasen angelegt wird, wobei die Sensorspannung zumindest einen ersten Spannungspuls mit einem ersten Spannungsvektor und einen zweiten Spannungspuls mit einem zweiten Spannungsvektor aufweist, wobei der erste Spannungsvektor und der zweite Spannungsvektor in unterschiedliche Richtungen jeweils senkrecht zu der Rotationsachse ausgerichtet sind, dass in einem Schritt b) während des Anlegens der Sensorspannung zumindest ein erster Stromwert einer ersten der Phasen, zumindest ein zweiter Stromwert einer zweiten der Phasen und zumindest ein dritter Stromwert einer dritten der Phasen erfasst werden, dass in einem Schritt c) ein Summen-Stromvektor in Abhängigkeit von den erfassten Stromwerten aller der Phasen ermittelt wird, und dass in einem Schritt d) der Summen-Stromvektor mit zumindest einem ermittelten oder gespeicherten Referenz-Stromvektor verglichen wird, wobei in Abhängigkeit von dem Vergleich zumindest ein Verstärkungsfehler ermittelt wird. Unter einem Spannungspuls ist dabei eine angelegte Spannung zu verstehen, die zumindest einen Maximalwert und einen Minimalwert aufweist. Um eine gewünschte Ausrichtung des ersten Spannungsvektors und des zweiten Spannungsvektors der Sensorspannung zu erreichen, wird an mehreren der Phasen zeitgleich eine Spannung angelegt. Die unterschiedliche Ausrichtung des ersten Spannungspulses und des zweiten Spannungspulses bezieht sich auf ein senkrecht zu der Rotationsachse verlaufendes, zweiachsiges Koordinatensystem. Insbesondere handelt es sich um ein stationäres Koordinatensystem, also ein den ebenfalls stationären Phasen zugeordnetes Koordinatensystem. Die an den Phasen angelegte Sensorspannung bewirkt einen Strom durch die Phasen, also einen Sensorstrom, der durch die Strommesseinrichtungen erfasst wird. Zum Ermitteln des Summen-Stromvektors werden Stromwerte aller der Phasen ermittelt.

Gemäß einer bevorzugten Ausführungsform ist vorgesehen, dass in Abhängigkeit von dem ersten Stromwert und dem zweiten Stromwert zumindest ein erster Teilsummen-Stromvektor, in Abhängigkeit von dem ersten Stromwert und dem dritten Stromwert zumindest ein zweiter Teilsummen-Stromvektor und/oder in Abhängigkeit von dem zweiten Stromwert und dem dritten Stromwert zumindest ein dritter Teilsummen-Stromvektor jeweils als Referenz-Stromvektor ermittelt werden. Zum Ermitteln der Teilsummen-Stromvektoren werden also jeweils nur Stromwerte von zwei der Phasen berücksichtigt. Der Stromwert jeweils einer der Phasen wird demnach beim Ermitteln der Teilsummen-Stromvektoren ausgeschlossen. In dem Vergleich wird dann vorzugsweise eine Ausrichtung des Summen-Stromvektors mit einer Ausrichtung zumindest eines der Teilsummen-Stromvektoren verglichen. Insbesondere werden durch das Verfahren unausgeglichene Verstärkungsfehler ermittelt. Darunter sind solche Verstärkungsfehler zu verstehen, die nicht die Stromwerte aller der Phasen gleichermaßen betreffen. Die unausgeglichenen Verstärkungsfehler treten derart in Erscheinung, dass die Ausrichtung zumindest eines der Teilsummen-Stromvektoren nicht mit einer zu erwartenden Ausrichtung übereinstimmt.

Gemäß einer bevorzugten Ausführungsform ist vorgesehen, dass in dem Schritt d) zumindest zwei der Teilsummen-Stromvektoren ermittelt werden. In dem Schritt f) werden dann beide der ermittelten Teilsummen-Stromvektoren jeweils mit dem Summen-Stromvektor verglichen. Es ergibt sich daraus der Vorteil, dass unausgeglichene Verstärkungsfehler jeder der Strommesseinrichtungen durch das Verfahren ermittelbar sind.

Vorzugsweise wird die Sensorspannung derart angelegt, dass der erste Spannungsvektor und der zweite Spannungsvektor senkrecht zueinander ausgerichtet sind. Die derartig ausgestaltete Sensorspannung ist einerseits technisch einfach an den Phasen anlegbar. Andererseits resultiert aus einer derartig angelegten Sensorspannung eine unkomplizierte Auswertung der erfassten Stromwerte zum Ermitteln eines Verstärkungsfehlers.

Eine Weiterbildung der Erfindung sieht vor, dass die Sensorspannung derart angelegt wird, dass der erste Spannungspuls zumindest eine erste Schwingung und der zweite Spannungspuls zumindest eine zweite Schwingung aufweist. Unter einer Schwingung ist zu verstehen, dass Spannungswerte der Spannungspulse um einen Mittelwert beziehungsweise Nullwert schwanken. Die erste Schwingung und die zweite Schwingung weisen dabei jeweils zumindest eine Periode auf.

Vorzugsweise wird die Sensorspannung derart angelegt, dass die erste Schwingung und die zweite Schwingung zeitlich aufeinanderfolgen, insbesondere zeitlich unmittelbar aufeinanderfolgen. Die Sensorspannung wird also derart vorgegeben, dass sich die erste Schwingung und die zweite Schwingung nicht überlagern. Dadurch wird die Auswertung der erfassten Stromwerte beziehungsweise das Ermitteln eines Verstärkungsfehlers vereinfacht.

Vorzugsweise wird die Sensorspannung derart angelegt, dass eine Amplitude der ersten Schwingung einer Amplitude der zweiten Schwingung entspricht. Auch hierdurch wird die Auswertung der erfassten Stromwerte vereinfacht.

Gemäß einer bevorzugten Ausführungsform werden der erste Spannungspuls und/oder der zweite Spannungspuls als pulsweitenmodulierte Spannung angelegt. Somit handelt es sich bei der ersten Schwingung und/oder der zweiten Schwingung um eine Rechteckschwingung. Einerseits ist die pulsweitenmodulierte Spannung einfach vorgebbar beziehungsweise anlegbar. Andererseits sind mittels Pulsweitenmodulation Schwingungen mit hohen Frequenzen, insbesondere hochfrequente Schwingungen, erreichbar, was bei der Durchführung des Verfahrens vorteilhaft ist, wie später noch erläutert wird.

Vorzugsweise werden mehrere erste Stromwerte, mehrere zweite Stromwerte und mehrere dritte Stromwerte an aufeinanderfolgenden Zeitpunkten erfasst. Durch das Erfassen jeweils mehrerer Stromwerte wird die Genauigkeit des Verfahrens gesteigert. Vorzugsweise wird an jedem der aufeinanderfolgenden Zeitpunkte jeweils ein erster Stromwert, ein zweiter Stromwert und ein dritter Stromwert erfasst. Vorzugsweise werden Stromwerte an einem nullten Zeitpunkt erfasst, wobei an dem nullten Zeitpunkt ein Übergang von einem Nullwert des ersten Spannungspulses auf den Maximalwert des ersten Spannungspulses und ein Übergang von dem Maximalwert des zweiten Spannungspulses auf einen Nullwert des zweiten Spannungspulses stattfinden. Vorzugsweise werden alternativ oder zusätzlich Stromwerte an einem ersten Zeitpunkt erfasst, wobei an dem ersten Zeitpunkt ein Übergang von dem Maximalwert des ersten Spannungspulses auf den Minimalwert des ersten Spannungspulses stattfindet und der zweite Spannungspuls den Nullwert aufweist. Vorzugsweise werden alternativ oder zusätzlich Stromwerte an einem dritten Zeitpunkt erfasst, wobei an dem dritten Zeitpunkt ein Übergang von dem Minimalwert des ersten Spannungspulses auf den Maximalwert des ersten Spannungspulses stattfindet und der zweite Spannungspuls den Nullwert aufweist. Vorzugsweise werden alternativ oder zusätzlich Stromwerte an einem vierten Zeitpunkt erfasst, wobei an dem vierten Zeitpunkt ein Übergang von dem Maximalwert des ersten Spannungspulses auf den Nullwert des ersten Spannungspulses und ein Übergang von dem Nullwert des zweiten Spannungspulses auf den Maximalwert des zweiten Spannungspulses stattfinden. Vorzugsweise werden alternativ oder zusätzlich Stromwerte an einem fünften Zeitpunkt erfasst, wobei an dem fünften Zeitpunkt der erste Spannungspuls den Nullwert aufweist und ein Übergang von dem Maximalwert des zweiten Spannungspulses auf den Minimalwert des zweiten Spannungspulses stattfindet. Vorzugsweise werden alternativ oder zusätzlich Stromwerte an einem siebten Zeitpunkt erfasst, wobei an dem siebten Zeitpunkt der erste Spannungspuls den Nullwert aufweist und ein Übergang von dem Minimalwert des zweiten Spannungspulses auf den Maximalwert des zweiten Spannungspulses stattfindet. Unter dem Nullwert ist dabei ein Wert zu verstehen, dessen Spannungsbetrag dem Mittelwert des Spannungsbetrags des Maximums und des Minimums des jeweiligen Spannungspulses entspricht. Vorzugsweise ist der Betrag des Nullwerts 0, sodass bei Vorliegen des Nullwertes keine Spannung anliegt.

Gemäß einer bevorzugten Ausführungsform ist vorgesehen, dass die Sensorspannung auf eine Arbeitsspannung zum Antreiben des Rotors aufmoduliert wird. Unter einer Arbeitsspannung ist eine Spannung zu verstehen, die an den Phasen angelegt wird, um den Rotor anzutreiben. Die Sensorspannung wird auf die Rotorspannung aufmoduliert, sodass sich die beiden Spannungen überlagern, also zeitgleich an den Phasen anliegen. Daraus ergibt sich der Vorteil, dass ein Einfluss eines Rotorwinkels des Rotors auf das Ermitteln des Verstärkungsfehlers mittels eines Tiefpassfilters ausgeschlossen werden kann.

Vorzugsweise wird die Sensorspannung derart angelegt, dass die erste und/oder die zweite Schwingung eine Frequenz aufweisen, die größer, insbesondere wesentlich größer, ist als eine Frequenz der Arbeitsspannung. Vorzugsweise wird die Sensorspannung so angelegt, dass die Frequenz der ersten und/oder der zweiten Spannung derart größer ist als die Frequenz der Arbeitsspannung, dass davon ausgegangen werden kann, dass eine Änderung des Arbeitsstroms während der ersten Schwingung beziehungsweise der zweiten Schwingung eine konstante Steigung aufweist. Durch ein derartiges Anlegen der Sensorspannung wird eine Auswertung der erfassten Stromwerte und damit das Ermitteln eines Verstärkungsfehlers vereinfacht.

Gemäß einer bevorzugten Ausführungsform ist vorgesehen, dass als Referenz-Stromvektor zumindest ein gespeicherter Referenz-Summen-Stromvektor, der einem zu erwartenden Summen-Stromvektor im fehlerfreien Betrieb der Sensoreinheit entspricht, verglichen wird. Daraus ergibt sich der Vorteil, dass ausgeglichene Verstärkungsfehler ermittelbar sind. Unter einem ausgeglichenen Verstärkungsfehler ist ein Fehler zu verstehen, der bewirkt, dass die erfassten Stromwerte aller der Phasen gleichermaßen fehlerhaft verstärkt werden. Vorzugsweise wird zum Ermitteln des ausgeglichenen Verstärkungsfehlers ein Betrag des Summen-Stromvektors mit einem Betrag des Referenz-Summen-Stromvektors verglichen.

Vorzugsweise wir bei Ermitteln eines Verstärkungsfehlers zumindest ein zum Verstärken der erfassten Stromwerte verwendeter Korrekturfaktor angepasst.

Durch das Anpassen des Korrekturfaktors wird der Verstärkungsfehler verringert. Dadurch wird eine Effizienz beim Betreiben der elektrischen Maschine gesteigert.

Die Erfindung betrifft außerdem eine Vorrichtung zum Ermitteln eines Verstärkungsfehlers zumindest einer Strommesseinrichtung einer Sensoreinheit einer elektrischen Maschine, wobei die Maschine eine Statorwicklung mit zumindest drei Phasen, zumindest eine mit jeder der Phasen verbundene Strom- und/oder Spannungsquelle, und einen Rotor aufweist, der um eine Rotationsachse drehbar gelagert ist, wobei die Sensoreinheit zumindest drei Strommesseinrichtungen aufweist, wobei jede der Strommesseinrichtungen jeweils einer anderen der Phasen zugeordnet ist. Die Vorrichtung zeichnet sich mit den Merkmalen des Anspruchs 14 durch ihre Ausbildung als Steuergerät aus und dadurch, dass sie als Steuergerät speziell dazu hergerichtet ist, bei bestimmungsgemäßem Gebrauch das erfindungsgemäße Verfahren durchzuführen. Auch daraus ergeben sich die bereits genannten Vorteile. Weitere bevorzugte Merkmale und Merkmalskombinationen ergeben sich aus dem zuvor Beschriebenen sowie aus den Ansprüchen.

Im Folgenden wird die Erfindung anhand der Zeichnungen näher erläutert, wobei gleiche und entsprechende Elemente in den Figuren mit den gleichen Bezugszeichen versehen sind. Dazu zeigen:

Figur 1    Eine elektrische Maschine mit einer Sensoreinheit,

Figur 2    ein Verfahren zum Ermitteln eines Verstärkungsfehlers zumindest einer Strommesseinrichtung der Sensoreinheit,

Figur 3    einen Verlauf eines an Phasen der Maschine angelegten Sensorstroms, und

Figur 4    einen Regelkreis mit einer Vorrichtung zum Ermitteln des Verstärkungsfehlers.

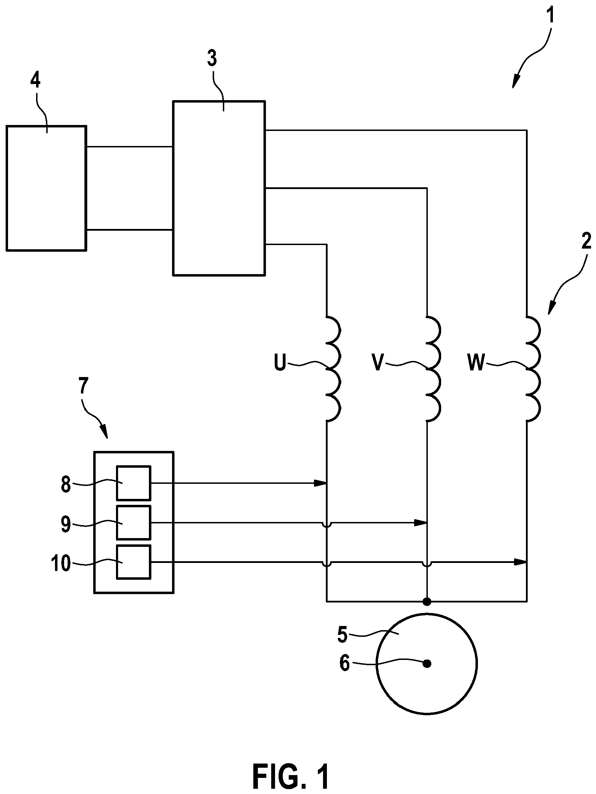

Figur 1 zeigt in einer schematischen Darstellung eine elektrische Maschine 1. Bei der Maschine 1 handelt es sich beispielsweise um eine elektrische Antriebsmaschine eines nicht dargestellten Fahrzeugs. Die Maschine 1 weist eine Statorwicklung 2 mit einer ersten Phase U, einer zweiten Phase V und einer dritten Phase W auf. Die Phasen U, V und W sind durch eine Leistungselektronik 3 mit einer Spannungsquelle 4, vorliegend einer Traktionsbatterie des Fahrzeugs, verbunden, sodass mittels der Spannungsquelle 4 die Phasen U, V und W bestrombar sind. Die elektrische Maschine 1 weist außerdem einen Rotor 5 auf, der um eine Rotationsachse 6 drehbar gelagert ist. Der Übersichtlichkeit halber sind die Phasen U, V und W in Figur 1 nebeneinander und oberhalb des Rotors 5 dargestellt. Jedoch sind die Phasen tatsächlich derart verteilt um den Rotor 5 angeordnet, dass der Rotor 5 durch eine geeignete Bestromung der Phasen U, V und W antreibbar beziehungsweise drehbar ist.

Die elektrische Maschine 1 weist außerdem eine Sensoreinheit 7 auf. Die Sensoreinheit 7 umfasst vorliegend drei Strommesseinrichtungen 8, 9 und 10. Die Strommesseinrichtungen 8, 9 und 10 sind zur Erfassung eines elektrischen Stroms durch die Phasen U, V und W jeweils einer anderen der Phasen U, V und W zugeordnet. Gemäß Figur 1 ist eine erste Strommesseinrichtung 8 der ersten Phase U zugeordnet, eine zweite Strommesseinrichtung 9 der zweiten Phase V und eine dritte Strommesseinrichtung 10 der dritten Phase W. Dabei ist vorgesehen, dass der erfasste Strom beziehungsweise erfasste verstärkt werden. Beim Verstärken der Stromwerte können Verstärkungsfehler auftreten. Diese bewirken, dass ein ausgegebener verstärkter Stromwert, also ein Ausgangswert, nicht einem zu erwartenden Wert entspricht. Der Ausgangswert ist dabei größer oder kleiner als der zu erwartende Wert. Es findet in diesem Fall also eine fehlerhafte Verstärkung statt.

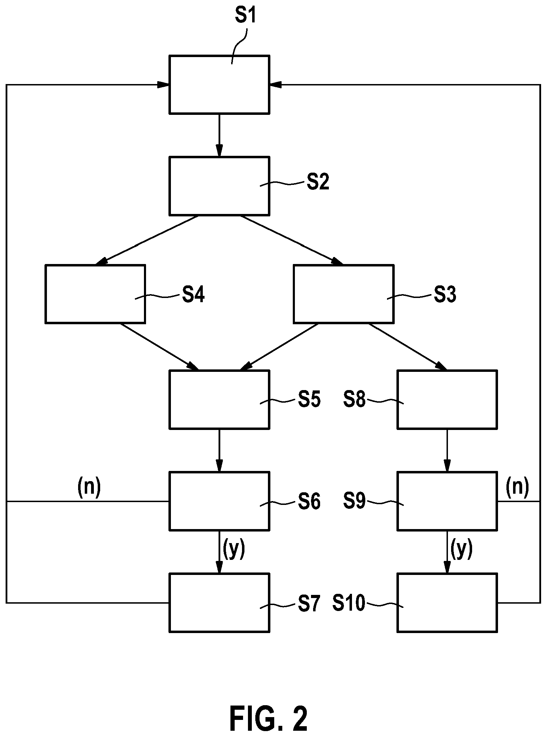

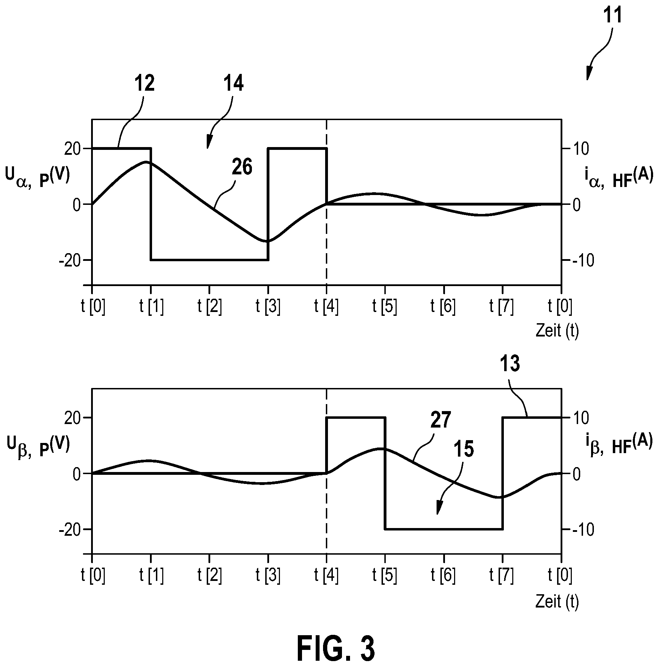

Im Folgenden wird mit Bezug auf Figur 2 ein Verfahren zum Ermitteln eines Verstärkungsfehlers erläutert. Figur 2 zeigt das Verfahren anhand eines Flussdiagramms. In einem Schritt S1 wird eine Sensorspannung 11 an den Phasen U, V und W angelegt. Dies erfolgt beispielsweise mittels der Spannungsquelle 4. Alternativ dazu ist eine weitere Strom- und/oder Spannungsquelle zum Anlegen der Sensorspannung 11 an den Phasen U, V und W vorhanden. Die Ausgestaltung der angelegten Sensorspannung 11 ist in Figur 3 dargestellt. Diese zeigt in einem oberen Teil der Figur 3 einen ersten Spannungspuls 12 der Sensorspannung 11 und einen aus dem ersten Spannungspuls 12 resultierenden Stromverlauf 26. In einem unteren Teil der Figur 3 sind ein zweiter Spannungspuls 13 der Sensorspannung 11 und ein aus dem zweiten Spannungspuls 13 resultierender Stromverlauf 27 dargestellt. Der erste Spannungspuls 12 weist eine erste Schwingung 14 auf. Analog dazu weist der zweite Spannungspuls 13 eine zweite Schwingung 15 auf. Die erste Schwingung 14 und die zweite Schwingung 15 folgen zeitlich unmittelbar aufeinander. Vorliegend erstreckt sich die erste Schwingung 14 über einen Zeitraum zwischen einem nullten Zeitpunkt t[0] und einem vierten Zeitpunkt t[4]. Die zweite Schwingung 15 erstreckt sich über einen Zeitraum zwischen dem vierten Zeitpunkt t[4] und dem nullten Zeitpunkt t[0]. Wie aus Figur 3 ersichtlich ist, erstreckt sich die erste Schwingung 14 über einen gleichlangen Zeitraum wie die zweite Schwingung 15. Außerdem weist die erste Schwingung 14 eine Amplitude auf, die einer Amplitude der zweiten Spannung 15 entspricht. Ferner sind beide Schwingungen 14 und 15 jeweils zu ihrem zeitlichen Mittelpunkt symmetrisch. Das heißt, dass die erste Schwingung 14 symmetrisch zu dem Zeitpunkt t[2] ist und die zweite Schwingung 15 symmetrisch zu dem Zeitpunkt t[6]. Der erste Spannungspuls 12 weist einen ersten Spannungsvektor auf. Analog dazu weist der zweite Spannungspuls 13 einen zweiten Spannungsvektor auf. Die beiden Spannungsvektoren sind in unterschiedliche Richtungen und jeweils senkrecht zu der Rotationsachse 6 ausgerichtet. Vorliegend ist der erste Spannungsvektor in Richtung einer erste Achse $\alpha$ ausgerichtet. Der zweite Spannungsvektor ist in Richtung einer senkrecht zu der ersten Achse $\alpha$ ausgerichteten zweiten Achse $\beta$ ausgerichtet. Die beiden Achsen $\alpha$ und $\beta$ definieren ein zweiachsiges, senkrecht zu der Rotationsachse 6 verlaufendes Koordinatensystem. Insbesondere handelt es sich um ein stationäres Koordinatensystem, also ein den Phasen U, V und W zugeordnetes Koordinatensystem. Zusammenfassend sind die Schwingungen 14 und 15 beziehungsweise die Spannungspulse 12 und 13 abgesehen von der Ausrichtung ihrer Spannungsvektoren und dem Zeitraum, in dem sie angelegt werden, zumindest im Wesentlichen gleichförmig ausgebildet.

In einem Schritt S2 des in Figur 2 dargestellten Verfahrens werden während des Anlegens der Sensorspannung 11 zumindest ein erster Stromwert der ersten Phase U, ein zweiter Stromwert der zweiten Phase V und ein dritter Stromwert der dritten Phase W erfasst. Vorzugsweise wird zu verschiedenen Zeitpunkten jeweils ein erster Stromwert, ein zweiter Stromwert und ein dritter Stromwert erfasst. Vorliegend wird jeweils ein erster Stromwert, ein zweiter Stromwert und ein dritter Stromwert zumindest zu den Zeitpunkten t[0], t[1], t[3], t[4], t[5] und t[7] erfasst.

Vorzugsweise wird in dem Schritt S1 gleichzeitig zu der Sensorspannung 11 auch eine Arbeitsspannung zum Antreiben des Rotors beziehungsweise zum Erzeugen eines Drehmoments an den Phasen U, V und W angelegt. Um Verstärkungsfehler zu ermitteln, wird ein durch die Sensorspannung 11 bewirkter Strom 26, 27 aus einem erfassten Gesamtstrom extrahiert. Es wird also nur der Teil des Gesamtstroms beim Ermitteln von Verstärkungsfehlern berücksichtigt, der durch die angelegte Sensorspannung 11 bewirkt wird.

In einem Schritt S3 wird in Abhängigkeit der erfassten Stromwerte aller der Phasen ein Summen-Stromvektor ermittelt. Vorliegend werden hierzu die nachfolgenden Formeln (1.1), (1.2) und (1.3) verwendet.

$$\Delta\underline{i}_{\alpha\beta,HF,\Sigma,1} = \frac{1}{4}\left(2 \times \underline{i}_{\alpha\beta}[1] - 2 \times \underline{i}_{\alpha\beta}[3] - \underline{i}_{\alpha\beta}[0] + \underline{i}_{\alpha\beta}[4]\right) \tag{1.1}$$

$$\Delta\underline{i}_{\alpha\beta,HF,\Sigma,2} = \frac{1}{4}\left(2 \times \underline{i}_{\alpha\beta}[5] - 2 \times \underline{i}_{\alpha\beta}[7] - \underline{i}_{\alpha\beta}[4] + \underline{i}_{\alpha\beta}[0]\right) \tag{1.2}$$

$$\Delta\underline{i}_{\alpha\beta,HF,\Sigma} = LPF\left\{\frac{1}{2} \times \left(\Delta\underline{i}_{\alpha\beta,HF,\Sigma,1} + e^{-j\pi/2} \times \Delta\underline{i}_{\alpha\beta,HF,\Sigma,2}\right)\right\} \tag{1.3}$$

Dabei beschreibt der Term $\underline{i}_{\alpha\beta}[k]$ einen erfassten beziehungsweise ermittelten Stromvektor zum Zeitpunkt t[k]. LPF bezeichnet einen beim Ermitteln des Summen-Stromvektors verwendeten Tiefpassfilter. Der Summen-Stromvektor wird durch den Term $\Delta\underline{i}_{\alpha\beta,HF,\Sigma}$ beschrieben. Um den Summen-Stromvektor zu ermitteln, werden beim Ermitteln der Stromvektoren $\underline{i}_{\alpha\beta}[k]$ jeweils die zu dem Zeitpunkt t[k] erfassten Stromwerte aller der Phasen U,V und W berücksichtigt.

In einem Schritt S4 wird zumindest ein Teilsummen-Stromvektor ermittelt. Vorliegend werden zwei Teilsummen-Stromvektoren ermittelt. Analog zu dem Summen-Stromvektor werden auch die Teilsummen-Stromvektoren mittels der Formeln (1.1), (1.2) und (1.3) ermittelt und durch den Term $\Delta\underline{i}_{\alpha\beta,HF,\Sigma}$ beschrieben. Im Unterschied zu dem Summen-Stromvektor werden beim Ermitteln der Teilsummen-Stromvektoren allerdings nicht jeweils die erfassten Stromwerte aller der Phasen U, V und W berücksichtigt. Vorliegend wird ein erster Teilsummen-Stromvektor in Abhängigkeit von den erfassten Stromwerten der ersten Phase U und den erfassten Stromwerten der zweiten Phase V ermittelt. Hierzu werden beim Ermitteln der Stromvektoren $\underline{i}_{\alpha\beta}[k]$ lediglich die Stromwerte dieser Phasen U und V berücksichtigt. Zusätzlich wird ein zweiter Teilsummen-Stromvektor in Abhängigkeit von den erfassten Stromwerten der ersten Phase U und der dritten Phase W ermittelt. Hierzu werden beim Ermitteln der Stromvektoren $i_{\alpha\beta}[k]$ lediglich die Stromwerte dieser Phasen U und W berücksichtigt. Zusätzlich oder alternativ zu dem ersten Teilsummen-Stromvektor oder dem zweiten Teilsummen-Stromvektor wird vorzugsweise ein dritter Teilsummen-Stromvektor ermittelt, wobei der dritte Teilsummen-Stromvektor in Abhängigkeit von erfassten Stromwerten der Phasen V und W ermittelt wird.

In einem Schritt S5 wird der Summen-Stromvektor mit den Teilsummen-Stromvektoren verglichen. Beispielsweise wird eine Ausrichtung des Summen-Stromvektors mit einer Ausrichtung des ersten Teilsummen-Stromvektors beziehungsweise einer Ausrichtung des zweiten Teilsummen-Stromvektors verglichen. In einem Schritt S6 wird in Abhängigkeit von dem Vergleich festgestellt, ob ein Verstärkungsfehler vorliegt. Beispielsweise wird festgestellt, dass ein Verstärkungsfehler vorliegt, wenn der Vergleich ergibt, dass einer der Teilsummen-Stromvektoren eine fehlerhafte beziehungsweise unerwartete Ausrichtung aufweist. Wird festgestellt, dass kein Verstärkungsfehler vorliegt (n), so wird auf den Schritt S1 zurückverwiesen. Wird in dem Schritt S6 jedoch festgestellt, dass ein Verstärkungsfehler vorliegt (y), so werden in einem Schritt S7 Maßnahmen ergriffen, um den Verstärkungsfehler zu beheben. Beispielsweise wird zum Beheben des Verstärkungsfehlers zumindest ein beim Verstärken verwendeter Korrekturfaktor angepasst. Im Anschluss an den Schritt S7 wird wieder auf den Schritt S1 zurückverwiesen.

In einem optionalen Schritt S8 wird der Summen-Stromvektor mit einem Referenz-Summen-Stromvektor verglichen. Bei dem Referenz-Summen-Stromvektor handelt es sich um einen im fehlerfreien Betrieb der Sensoreinheit 7 ermittelten Summen-Stromvektor. Vorliegend wird in dem Schritt S8 ein Betrag des ermittelten Summen-Stromvektors mit einem Betrag des Referenz-Summen-Stromvektors verglichen. In Abhängigkeit von dem in dem Schritt S8 durchgeführten Vergleich wird in einem Schritt S9 festgestellt, ob ein ausgeglichener Verstärkungsfehler vorliegt, also ein Verstärkungsfehler, der die durch die Strommesseinrichtungen 8, 9 und 10 erfassten Stromwerte gleichermaßen betrifft. Falls kein ausgeglichener Verstärkungsfehler vorliegt (n), wird auf den Schritt S1 zurückverwiesen. Wird in dem Schritt S9 jedoch ein ausgeglichener Verstärkungsfehler festgestellt, werden in einem Schritt S10 die Korrekturfaktoren der Strommesseinrichtungen 8, 9 und 10 angepasst und es wird anschließend auf den Schritt S1 zurückverwiesen.

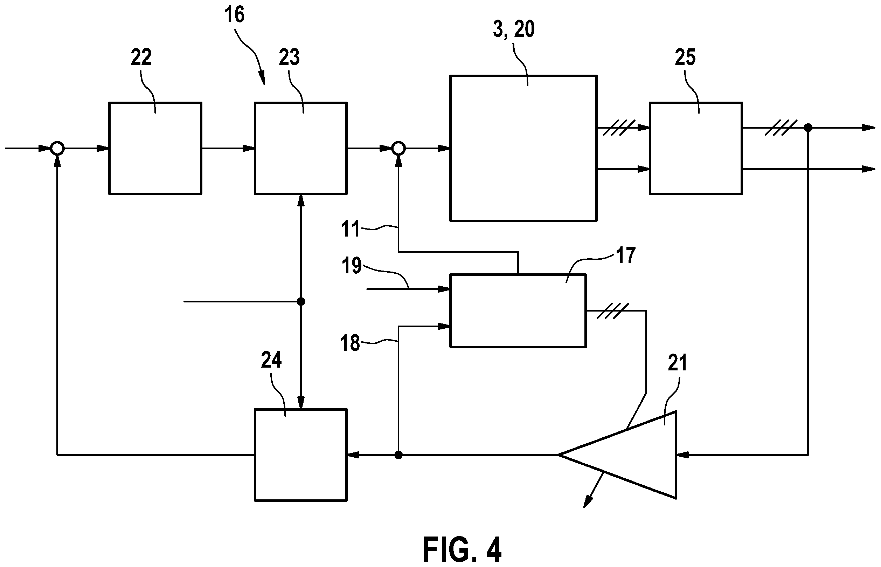

Figur 4 zeigt einen Regelkreis 16 mit einer als Steuergerät ausgebildeten Vorrichtung 17. Die Vorrichtung 17 ist dazu ausgebildet, das mit Bezug auf Figur 2 erläuterte Verfahren durchzuführen, also zumindest einen Verstärkungsfehler zu ermitteln. Der Vorrichtung 17 werden die mittels der Strommesseinrichtungen 8, 9 und 10 erfassten und verstärkten Stromwerte 18, also die ersten Stromwerte, die zweiten Stromwerte und die dritten Stromwerte, zur Verfügung gestellt. Außerdem wird der Vorrichtung 17 ein Referenz-Summen-Stromvektor zur Verfügung gestellt. Ferner wird der Vorrichtung 17 ein Wert 19 zur Verfügung gestellt, der ein durch die elektrische Maschine 1 zu erzeugendes Drehmoment beschreibt. Ausgangsseitig ist die Vorrichtung 17 mit der Leistungselektronik 3 oder einem Steuergerät 20 zur Ansteuerung der Leistungselektronik 3 verbunden und dazu ausgebildet, der Leistungselektronik 3 beziehungsweise dem Steuergerät 20 die anzulegende Sensorspannung 11 vorzugeben. Die Sensorspannung 11 wird dabei vorzugsweise in Abhängigkeit von dem Wert 19 vorgegeben. Außerdem ist die Vorrichtung 17 ausgangsseitig mit einer Korrektureinrichtung 21 verbunden, in der aktuelle Werte der Korrekturfaktoren gespeichert sind. Die Vorrichtung 17 ist entweder dazu ausgebildet, der Korrektureinrichtung angepasste Korrekturfaktoren bereitzustellen oder der Korrektureinrichtung 21 eine Information zu übermitteln, wobei die Korrektureinrichtung 21 dazu ausgebildet ist, in Abhängigkeit von der Information die Korrekturfaktoren selbst anzupassen. Der Regelkreis 16 weist außerdem einen Stromregler 22, eine erste Koordinatentransformationseinrichtung 23 und eine zweite Koordinatentransformationseinrichtung 24 auf. Die erste Koordinatentransformationseinrichtung 23 ist insbesondere dazu ausgebildet, Werte eines rotierenden Koordinatensystems in Werte des stationären Koordinatensystems zu transformieren. Die zweite Koordinatentransformationseinrichtung 24 ist insbesondere dazu ausgebildet, mehrphasige, insbesondere dreiphasige, Werte, in ein zweiachsiges Koordinatensystem zu transformieren. Ferner weist der Regelkreis 16 ein Sensorsystem 25 auf. Das Sensorsystem umfasst beispielsweise die Sensoreinheit 7 sowie eine Messeinrichtung, die dazu ausgebildet ist, einen Drehwinkel des Rotors 5 zu erfassen.

**Patentansprüche**

1.  Verfahren zum Ermitteln eines Verstärkungsfehlers zumindest einer Strommesseinrichtung (8, 9, 10) einer Sensoreinheit (7) einer elektrischen Maschine (1), wobei die Maschine (1) eine Statorwicklung (2) mit zumindest drei Phasen (U, V, W) und einen Rotor (5) aufweist, der um eine Rotationsachse (6) drehbar gelagert ist, mit folgenden Schritten:

    a) Anlegen einer elektrischen Sensorspannung (11) an den Phasen (U, V, W), wobei die Sensorspannung (11) zumindest einen ersten Spannungspuls (12) mit einem ersten Spannungsvektor und einen zweiten Spannungspuls (13) mit einem zweiten Spannungsvektor aufweist, wobei der erste Spannungsvektor und der zweite Spannungsvektor in unterschiedliche Richtungen jeweils senkrecht zu der Rotationsachse (6) ausgerichtet sind,

b) Während des Anlegens der Sensorspannung (11), Erfassen zumindest eines ersten Stromwertes einer ersten der Phasen (U), zumindest eines zweiten Stromwertes einer zweiten der Phasen (V) und zumindest eines dritten Stromwertes einer dritten der Phasen (W),

**dadurch gekennzeichnet, dass** das Verfahren die Schritte umfasst:

c) Ermitteln eines Summen-Stromvektors in Abhängigkeit von den erfassten Stromwerten aller der Phasen (U, V, W),

d) Vergleichen des Summen-Stromvektors mit zumindest einem ermittelten oder gespeicherten Referenz-Stromvektor und Ermitteln zumindest eines Verstärkungsfehlers in Abhängigkeit von dem Vergleich.

2. Verfahren nach Anspruch 1, **dadurch gekennzeichnet, dass** in Abhängigkeit von dem ersten Stromwert und dem zweiten Stromwert zumindest ein erster Teilsummen-Stromvektor, in Abhängigkeit von dem ersten Stromwert und dem dritten Stromwert zumindest ein zweiter Teilsummen-Stromvektor und/oder in Abhängigkeit von dem zweiten Stromwert und dem dritten Stromwert zumindest ein dritter Teilsummen-Stromvektor jeweils als Referenz-Stromvektor ermittelt werden.

3. Verfahren nach Anspruch 2, **dadurch gekennzeichnet, dass** zumindest zwei der Teilsummen-Stromvektoren ermittelt werden.

4. Verfahren nach einem der vorhergehenden Ansprüche, **dadurch gekennzeichnet, dass** die Sensorspannung (11) derart angelegt wird, dass der erste Spannungsvektor und der zweite Spannungsvektor senkrecht zueinander ausgerichtet sind.

5. Verfahren nach einem der vorhergehenden Ansprüche, **dadurch gekennzeichnet, dass** die Sensorspannung (11) derart angelegt wird, dass der erste Spannungspuls (12) zumindest eine erste Schwingung (14) und/oder der zweite Spannungspuls (13) zumindest eine zweite Schwingung (15) aufweist.

6. Verfahren nach Anspruch 5, **dadurch gekennzeichnet, dass** die Sensorspannung (11) derart angelegt wird, dass die erste Schwingung (14) und die zweite Schwingung (15) zeitlich aufeinanderfolgen, insbesondere zeitlich unmittelbar aufeinanderfolgen.

7. Verfahren nach einem der Ansprüche 5 und 6, **dadurch gekennzeichnet, dass** die Sensorspannung (11) derart angelegt wird, dass eine Amplitude der ersten Schwingung (14) einer Amplitude der zweiten Schwingung (15) entspricht.

8. Verfahren nach einem der vorhergehenden Ansprüche, **dadurch gekennzeichnet, dass** der erste Spannungspuls (12) und/oder der zweite Spannungspuls (13) als pulsweitenmodulierte Spannung angelegt werden.

9. Verfahren nach einem der vorhergehenden Ansprüche, **dadurch gekennzeichnet, dass** mehrere erste Stromwerte, mehrere zweite Stromwerte und mehrere dritte Stromwerte an aufeinanderfolgenden Zeitpunkten erfasst werden.

10. Verfahren nach einem der vorhergehenden Ansprüche, **dadurch gekennzeichnet, dass** die Sensorspannung (11) auf eine Arbeitsspannung zum Antreiben des Rotors (5) aufmoduliert wird.

11. Verfahren nach Anspruch 10, **dadurch gekennzeichnet, dass** die erste und/oder die zweite Schwingung (14, 15) eine Frequenz aufweisen, die größer ist als eine Frequenz der Arbeitsspannung.

12. Verfahren nach einem der vorhergehenden Ansprüche, **dadurch gekennzeichnet, dass** als Referenz-Stromvektor zumindest ein gespeicherter Referenz-Summen-Stromvektor, der einem zu erwartenden Summen-Stromvektor im fehlerfreien Betrieb der Sensoreinheit (7) entspricht, verwendet wird.

13. Verfahren nach einem der vorhergehenden Ansprüche, **dadurch gekennzeichnet, dass** bei Ermitteln eines Verstärkungsfehlers zumindest ein zum Verstärken der erfassten Stromwerte verwendeter Korrekturfaktor angepasst wird.

14. Vorrichtung (17) zum Ermitteln eines Verstärkungsfehlers zumindest einer Strommesseinrichtung (8, 9, 10) einer Sensoreinheit (7) einer elektrischen Maschine (1), wobei die Maschine (1) eine Statorwicklung (2) mit zumindest drei Phasen (U, V, W), zumindest eine mit jeder der Phasen (U, V, W) verbundene Strom- und/oder Spannungsquelle (4), und einen Rotor (5) aufweist, der um eine Rotationsachse (6) drehbar gelagert ist, wobei die Sensoreinheit (7) zumindest drei Strommesseinrichtungen (8, 9, 10) aufweist, wobei jede der Strommesseinrichtungen (8, 9, 10) jeweils einer anderen der Phasen (U, V, W) zugeordnet ist, **dadurch gekennzeichnet, dass** die als Steuergerät ausgebildete Vorrichtung (17) speziell dazu hergerichtet ist, bei bestimmungsgemäßem Gebrauch das Verfahren gemäß einem der Ansprüche 1 bis 13 durchzuführen.

**Claims**

1. Method for ascertaining a gain error of at least one current measuring device (8, 9, 10) of a sensor unit (7) of an electrical machine (1), wherein the machine (1) comprises a stator winding (2) with at least three phases (U, V, W) and a rotor (5) that is mounted rotatably about an axis of rotation (6), having the following steps:

   a) application of an electrical sensor voltage (11) to the phases (U, V, W), wherein the sensor voltage (11) comprises at least one first voltage pulse (12) with a first voltage vector and one second voltage pulse (13) with a second voltage vector, wherein the first voltage vector and the second voltage vector are each oriented in different directions perpendicular to the axis of rotation (6),
   b) acquisition, during the application of the sensor voltage (11), of at least one first current value of a first of the phases (U), at least one second current value of a second of the phases (V) and at least one third current value of a third of the phases (W),

   **characterized in that** the method comprises the steps of:

   c) ascertainment of a sum current vector depending on the acquired current values of all of the phases (U, V, W),
   d) comparison of the sum current vector with at least one ascertained or stored reference current vector, and ascertainment of at least one gain error depending on the comparison.

2. Method according to Claim 1, **characterized in that** at least one first partial sum current vector is ascertained depending on the first current value and the second current value, at least one second partial sum current vector is ascertained depending on the first current value and the third current value, and/or at least one third partial sum current vector is ascertained depending on the second current value and the third current value, as a reference current vector in each case.

3. Method according to Claim 2, **characterized in that** at least two of the partial sum current vectors are ascertained.

4. Method according to one of the preceding claims, **characterized in that** the sensor voltage (11) is applied in such a way that the first voltage vector and the second voltage vector are oriented perpendicularly to one another.

5. Method according to one of the preceding claims, **characterized in that** the sensor voltage (11) is applied in such a way that the first voltage pulse (12) comprises at least one first oscillation (14) and/or the second voltage pulse (13) comprises at least one second oscillation (15).

6. Method according to Claim 5, **characterized in that** the sensor voltage (11) is applied in such a way that the first oscillation (14) and the second oscillation (15) follow one another in time, in particular follow one another immediately.

7. Method according to one of Claims 5 and 6, **characterized in that** the sensor voltage (11) is applied in such a way that an amplitude of the first oscillation (14) corresponds to an amplitude of the second oscillation (15).

8. Method according to one of the preceding claims, **characterized in that** the first voltage pulse (12) and/or the second voltage pulse (13) are/is applied as a pulse-width modulated voltage.

9. Method according to one of the preceding claims, **characterized in that** multiple first current values, multiple second current values and multiple third current values are acquired at sequential time points.

10. Method according to one of the preceding claims, **characterized in that** the sensor voltage (11) is modulated onto a working voltage for driving the rotor (5).

**11.** Method according to Claim 10, **characterized in that** the first and/or the second oscillation (14, 15) have/has a frequency that is greater than a frequency of the working voltage.

**12.** Method according to one of the preceding claims, **characterized in that** at least one stored reference sum current vector that corresponds to an expected sum current vector during fault-free operation of the sensor unit (7) is used as a reference current vector.

**13.** Method according to one of the preceding claims, **characterized in that** at least one correction factor used to amplify the acquired current values is adjusted when ascertaining a gain error.

**14.** Apparatus (17) for ascertaining a gain error of at least one current measuring device (8, 9, 10) of a sensor unit (7) of an electrical machine (1), wherein the machine (1) comprises a stator winding (2) with at least three phases (U, V, W), at least one current and/or voltage source (4) connected to each of the phases (U, V, W) and a rotor (5) that is mounted rotatably about an axis of rotation (6), wherein the sensor unit (7) comprises at least three current measuring devices (8, 9, 10), wherein each of the current measuring devices (8, 9, 10) is respectively assigned to a different one of the phases (U, V, W), **characterized in that** the apparatus (17) that is designed as a control device is in particular set up to carry out the method according to one of Claims 1 to 13 when used as intended.

**Revendications**

**1.** Procédé permettant de déterminer une erreur d'amplification d'au moins un dispositif de mesure de courant (8, 9, 10) d'une unité de détection (7) d'une machine électrique (1), la machine (1) présentant un enroulement de stator (2) doté d'au moins trois phases (U, V, W) et un rotor (5) qui est monté rotatif autour d'un axe de rotation (6), comprenant les étapes suivantes consistant à :

a) appliquer une tension de capteur électrique (11) aux phases (U, V, W), la tension de capteur (11) présentant au moins une première impulsion de tension (12) avec un premier vecteur de tension et une deuxième impulsion de tension (13) avec un deuxième vecteur de tension, le premier vecteur de tension et le deuxième vecteur de tension étant orientés dans différentes directions respectivement perpendiculairement à l'axe de rotation (6),
b) pendant l'application de la tension de capteur (11), détecter au moins une première valeur de courant d'une première des phases (U), au moins une deuxième valeur de courant d'une deuxième des phases (V), et au moins une troisième valeur de courant d'une troisième des phases (W),

**caractérisé en ce que** le procédé comprend les étapes consistant à :

c) déterminer un vecteur de courant de sommation en fonction des valeurs de courant détectées de toutes les phases (U, V, W),
d) comparer le vecteur de courant de sommation avec au moins un vecteur de courant de référence déterminé ou mémorisé, et déterminer au moins une erreur d'amplification en fonction de la comparaison.

**2.** Procédé selon la revendication 1, **caractérisé en ce qu'**au moins un premier vecteur de courant de sommation partielle est déterminé en fonction de la première valeur de courant et de la deuxième valeur de courant, au moins un deuxième vecteur de courant de sommation partielle est déterminé en fonction de la première valeur de courant et de la troisième valeur de courant, et/ou au moins un troisième vecteur de courant de sommation partielle est déterminé en fonction de la deuxième valeur de courant et de la troisième valeur de courant, respectivement comme un vecteur de courant de référence.

**3.** Procédé selon la revendication 2, **caractérisé en ce qu'**au moins deux des vecteurs de courant de sommation partielle sont déterminés.

**4.** Procédé selon l'une quelconque des revendications précédentes, **caractérisé en ce que** la tension de capteur (11) est appliquée de telle sorte que le premier vecteur de tension et le deuxième vecteur de tension sont orientés perpendiculairement l'un par rapport à l'autre.

**5.** Procédé selon l'une quelconque des revendications précédentes, **caractérisé en ce que** la tension de capteur (11) est appliquée de telle sorte que la première impulsion de tension (12) présente au moins une première oscillation (14), et/ou la deuxième impulsion de tension (13) présente au moins une deuxième oscillation (15).

6. Procédé selon la revendication 5, **caractérisé en ce que** la tension de capteur (11) est appliquée de telle sorte que la première oscillation (14) et la deuxième oscillation (15) sont consécutives, en particulier directement consécutives, dans le temps.

7. Procédé selon l'une quelconque des revendications 5 et 6, **caractérisé en ce que** la tension de capteur (11) est appliquée de telle sorte qu'une amplitude de la première oscillation (14) correspond à une amplitude de la deuxième oscillation (15).

8. Procédé selon l'une quelconque des revendications précédentes, **caractérisé en ce que** la première impulsion de tension (12) et/ou la deuxième impulsion de tension (13) sont appliquées comme une tension modulée en largeur d'impulsion.

9. Procédé selon l'une quelconque des revendications précédentes, **caractérisé en ce que** plusieurs premières valeurs de courant, plusieurs deuxièmes valeurs de courant et plusieurs troisièmes valeurs de courant sont détectées à des instants consécutifs.

10. Procédé selon l'une quelconque des revendications précédentes, **caractérisé en ce que** la tension de capteur (11) est modulée sur une tension de travail pour entraîner le rotor (5).

11. Procédé selon la revendication 10, **caractérisé en ce que** la première et/ou la deuxième oscillation (14, 15) présentent une fréquence qui est supérieure à une fréquence de la tension de travail.

12. Procédé selon l'une quelconque des revendications précédentes, **caractérisé en ce qu'**au moins un vecteur de courant de sommation de référence mémorisé, qui correspond à un vecteur de courant de sommation anticipé lors du fonctionnement correct de l'unité de détection (7), est utilisé comme vecteur de courant de référence.

13. Procédé selon l'une quelconque des revendications précédentes, **caractérisé en ce que** lors de la détermination d'une erreur d'amplification, au moins un facteur de correction utilisé pour amplifier les valeurs de courant détectées est adapté.

14. Dispositif (17) permettant de déterminer une erreur d'amplification d'au moins un dispositif de mesure de courant (8, 9, 10) d'une unité de détection (7) d'une machine électrique (1), la machine (1) présentant un enroulement de stator (2) pourvu d'au moins trois phases (U, V, W), au moins une source de courant et/ou de tension (4) reliée à chacune des phases (U, V, W), et un rotor (5) qui est monté rotatif autour d'un axe de rotation (6), dans lequel l'unité de détection (7) présente au moins trois dispositifs de mesure de courant (8, 9, 10), chacun des dispositifs de mesure de courant (8, 9, 10) étant respectivement associé à une autre des phases (U, V, W), **caractérisé en ce que** le dispositif (17), réalisé sous forme d'appareil de commande, est spécialement conçu pour exécuter en cours de fonctionnement conforme le procédé selon l'une quelconque des revendications 1 à 13.

**FIG. 1**

FIG. 2

**FIG. 3**

FIG. 4